(19) Europäisches Patentamt / European Patent Office / Office européen des brevets

(11) **EP 2 853 909 A1**

(12) **EUROPEAN PATENT APPLICATION**
published in accordance with Art. 153(4) EPC

(43) Date of publication:
**01.04.2015 Bulletin 2015/14**

(51) Int Cl.:
**G01R 33/09** (2006.01)     **H01L 43/08** (2006.01)

(21) Application number: **13790381.1**

(86) International application number:
**PCT/JP2013/002703**

(22) Date of filing: **22.04.2013**

(87) International publication number:
**WO 2013/171977 (21.11.2013 Gazette 2013/47)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **16.05.2012 JP 2012112497**

(71) Applicant: **Murata Manufacturing Co., Ltd.
Nagaokakyo-shi, Kyoto 617-8555 (JP)**

(72) Inventor: **ITAGAKI, Atsushi
Otsuki-shi, Yamanashi 401-0016 (JP)**

(74) Representative: **Reeve, Nicholas Edward
Reddie & Grose LLP
16 Theobalds Road
London WC1X 8PL (GB)**

(54) **BRIDGE CIRCUIT AND MAGNETIC SENSOR COMPRISING SAME**

(57) To provide a magnetic sensor having a large magnetic-field detection angle range and a bridge circuit used in the magnetic sensor, in each of multiple MR elements in the bridge circuit, multiple strips, on the whole, along a direction substantially orthogonal to a magnetic-field detection direction are arranged in parallel at certain intervals and are sequentially connected so as to be folded back and, in each of the multiple strips, multiple strips along the magnetic-field detection direction are arranged in parallel at certain intervals and are sequentially connected so as to be folded back to form a zigzag pattern in which the multiple strips are electrically connected in series to each other.

FIG. 1A

**Description**

Technical Field

The present invention relates to a bridge circuit and a magnetic sensor including the bridge circuit. More particularly, the present invention relates to a bridge circuit formed of four MR elements and a magnetic sensor including the bridge circuit.

Background Art

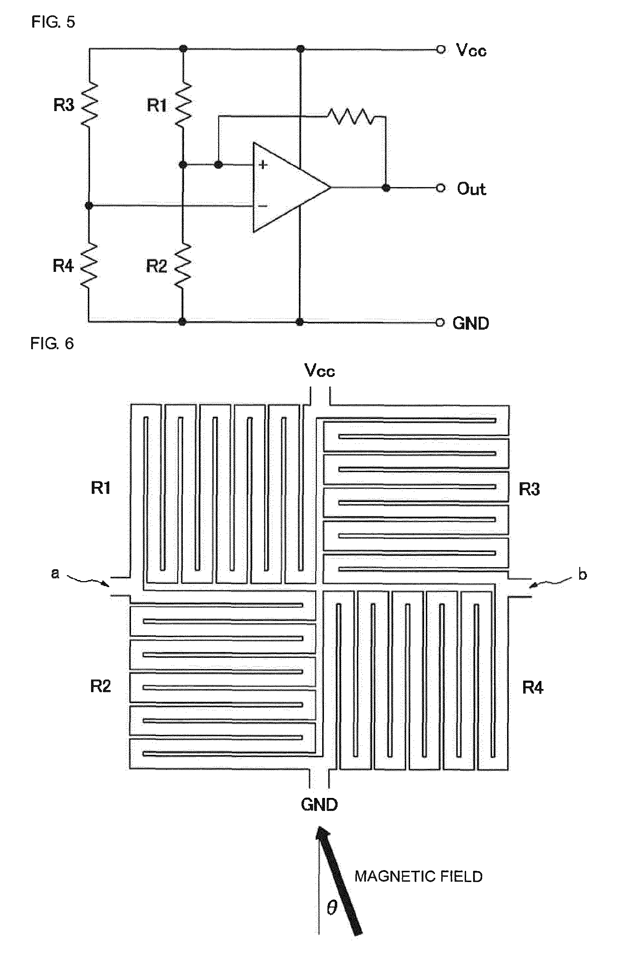

Magnetic sensors using magneto-resistance effect elements (MR elements) utilizing magneto-resistance effect (MR effect) are known. Fig. 5 is an equivalent circuit diagram of such a magnetic sensor. Specifically, the magnetic sensor includes a bridge circuit formed of four MR elements R1 to R4, a comparator that receives the potential between a node between the MR element R1 and the MR element R2 and a node between the MR element R3 and the MR element R4 to output the voltage corresponding to the potential difference, and a feedback resistor that feeds back the output from the comparator to one input. Such circuit elements are formed in the same chip to compose the magnetic sensor.

Fig. 6 is a plan view illustrating a pattern of the MR elements R1 to R4 in such a bridge circuit. Specifically, a serial connection body of the MR element R1 and the MR element R2 and a serial connection body of the MR element R3 and the MR element R4 are connected in parallel between power supply voltage Vcc and grounding GND. In each of the MR element R1 and the MR element R4 in the bridge circuit, multiple strips along a direction orthogonal to a magnetic-field detection direction are arranged in parallel at certain intervals and are sequentially connected so as to be folded back to form a zigzag pattern in which the multiple strips are electrically connected in series to each other. In each of the MR element R2 and the MR element R3 in the bridge circuit, multiple strips along the magnetic-field detection direction are arranged in parallel at certain intervals and are sequentially connected so as to be folded back to form a zigzag pattern in which the multiple strips are electrically connected in series to each other. Such a bridge circuit using the MR elements arranged in the zigzag patterns is proposed in Patent Document 1.

In detection of the position of a rotation operation, there are cases in which an operation angle range of the magnetic sensor is desirably increased as much as possible depending on applications. For example, liquid crystal screen portions of video cameras have rotation mechanisms and the orientations of images on the liquid crystal portions are inverted at angles that are set. At small detection angles, only slight rotation operations may invert the images on the liquid crystal portions. In order to increase the detection angle a little bit, it is necessary to increase magnets in size or devise the arrangement of the magnetic sensors. The degree of freedom of design is reduced with the decrease in size of terminals in recent years and it is desirable to provide the magnetic sensors having large detection angle ranges.

Citation List

Patent Document

Patent Document 1: Japanese Unexamined Patent Application Publication No. 2007-225421

Summary of Invention

Technical Problem

However, the magnetic sensors in the background art described above have the following problems.

Connecting the four MR elements R1 to R4 differing in at least one resistor body at the four nodes in a bridge pattern and applying power to opposing nodes cause offset voltage at the remaining opposing nodes. Specifically, connecting the serial connection body of the MR element R1 and the MR element R2 and the serial connection body of the MR element R3 and the MR element R4 in parallel between the power supply voltage Vcc and the grounding GND, as illustrated in Fig. 6, causes the offset voltage between a node a between the MR element R1 and the MR element R2 and a node b between the MR element R3 and the MR element R4. Upon application of the magnetic field, the MR elements output voltage. The detection level of a waveform shaping processor is set so as to be higher than the level based on the offset voltage from the MR elements. When the level based on the offset voltage from the MR elements exceeds the above detection level, the waveform shaping processor outputs a signal.

Upon application of magnetic field of $\angle\theta$ to the pattern illustrated in Fig. 6, relationship $R = R0 - \Delta R \times \sin^2\theta$ is established between an angle $\theta$ between the current flowing through the MR elements and the magnetic field and the resistance value of the MR elements. In this equation, R0: the resistance value of the MR elements under no magnetic field and ΔR: the amount of change of resistance upon application of the magnetic field.

The offset voltage between the nodes a and b when voltage V is applied is represented by (Formula 1):

(Formula 1)

$$
Vab = V \times \frac{(R2 - \Delta R2 \times cos^2\theta)}{(R1 - \Delta R1 \times sin^2\theta) + (R2 - \Delta R2 \times cos^2\theta)} - V \times \frac{(R4 - \Delta R4 \times sin^2\theta)}{(R3 - \Delta R3 \times cos^2\theta) + (R4 - \Delta R4 \times sin^2\theta)}
$$

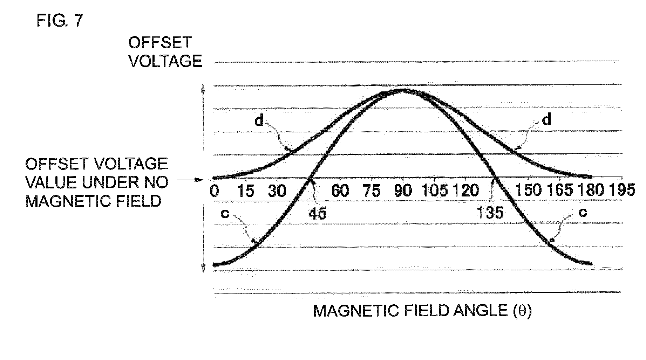

The relationship between the magnetic field of ∠θ and mid-point potential is represented by a curve c illustrated in Fig. 7. The angle of the magnetic field exceeding the offset voltage value under no magnetic field is limited to a range from 45° to 135°. In other words, no signal is output from the waveform shaping processor outside this angel range and nothing is detected.

Accordingly, it is an object of the present invention to provide a magnetic sensor having a large magnetic-field detection angle range and a bridge circuit used in the magnetic sensor.

Solution to Problem

In order to achieve the above object, a magnetic sensor according to the present invention includes a bridge circuit in which a serial connection body of a first MR element and a second MR element and a serial connection body of a third MR element and a fourth MR element are connected in parallel between power supplies, and a comparator that receives potential between a node between the first MR element and the second MR element and a node between the third MR element and the fourth MR element to have an output corresponding to a potential difference between both the nodes. In each of the first and fourth MR elements in the bridge circuit, multiple strips along a direction substantially orthogonal to a magnetic-field detection direction are arranged in parallel at certain intervals and are sequentially connected so as to be folded back to form a zigzag pattern in which the multiple strips are electrically connected in series to each other. In each of the second and third MR elements in the bridge circuit, multiple strips, on the whole, along the direction substantially orthogonal to the magnetic-field detection direction are arranged in parallel at certain intervals and are sequentially connected so as to be folded back and, in each of the multiple strips, multiple strips along the magnetic-field detection direction are arranged in parallel at certain intervals and are sequentially connected so as to be folded back to form a zigzag pattern in which the multiple strips are electrically connected in series to each other.

A bridge circuit according to the present invention is provided in which a serial connection body of a first MR element and a second MR element and a serial connection body of a third MR element and a fourth MR element are connected in parallel between power supplies. In each of the first and fourth MR elements, multiple strips along a direction substantially orthogonal to a magnetic-field detection direction are arranged in parallel at certain intervals and are sequentially connected so as to be folded back to form a zigzag pattern in which the multiple strips are electrically connected in series to each other. In each of the second and third MR elements, multiple strips, on the whole, along the direction substantially orthogonal to the magnetic-field detection direction are arranged in parallel at certain intervals and are sequentially connected so as to be folded back and, in each of the multiple strips, multiple strips along the magnetic-field detection direction are arranged in parallel at certain intervals and are sequentially connected so as to be folded back to form a zigzag pattern in which the multiple strips are electrically connected in series to each other.

Advantageous Effects of Invention

According to the present invention, it is possible to increase the magnetic-field detection angle range.

Brief Description of Drawings

[Fig. 1A] Fig. 1A is a plan view for describing a bridge circuit in a magnetic sensor according to a first embodiment of the present invention.
[Fig. 1B] Fig. 1B is a partially enlarged view for describing the shape of the bridge circuit in the magnetic sensor according to the first embodiment of the present invention in detail.

[Fig. 2] Fig. 2 is a graph illustrating the relationship between the line length of an MR element and the rate of change of resistance.

[Fig. 3] Fig. 3 is a plan view for describing a bridge circuit in a magnetic sensor according to a second embodiment of the present invention.

[Fig. 4A] Fig. 4A is a plan view for describing a bridge circuit in a magnetic sensor according to another embodiment of the present invention.

[Fig. 4B] Fig. 4B is a plan view for describing a bridge circuit in a magnetic sensor according to another embodiment of the present invention.

[Fig. 5] Fig. 5 is an equivalent circuit diagram of a magnetic sensor.

[Fig. 6] Fig. 6 is a plan view illustrating an exemplary MR pattern in a bridge circuit in a magnetic sensor.

[Fig. 7] Fig. 7 is a graph illustrating the relationship between magnetic field of ∠θ and mid-point potential.

Description of Embodiments

Before detailed description of preferred embodiments of the present invention, the offset voltage of the magnetic sensor will now be described again. If the MR elements R2 and R3 illustrated in Fig. 6 are replaced with resistor bodies that are not affected by the magnetic field, the offset voltage between the nodes a and b is represented by (Formula 2):

(Formula 2)

$$V_{ab} = V \times \frac{R2}{(R1 - \Delta R1 \times sin^2\theta) + R2} - V \times \frac{(R4 - \Delta R4 \times sin^2\theta)}{R3 + (R4 - \Delta R4 \times sin^2\theta)}$$

In this case, the relationship between the magnetic field of ∠θ and the mid-point potential is represented by a curve d illustrated in Fig. 7. The angle of the magnetic field exceeding the offset voltage value under no magnetic field is greatly increased, compared with the case in (Formula 1).

As described above, replacing the MR elements R2 and R3 in the bridge circuit with the resistor bodies that do not depend on the magnetic field allows the detection angle of the magnetic sensor to be increased. Accordingly, the MR elements R2 and R3 may be replaced with common semiconductor resistors. However, in consideration of practical mass production, the resistance values of the resistors made of semiconductor are varied from about ±10% to about 20%. Consequently, the relative precision with the MR elements is degraded and the balance of the mid-point potential is not capable of being controlled. Thus, the replacement of the MR elements R2 and R3 with the common semiconductor resistors is not practical.

Accordingly, in the present invention, the R2 and R3 in the bridge circuit, which are formed of the MR elements, are formed into a shape that is less affected by the magnetic field to increase the detection angle range.

(First embodiment)

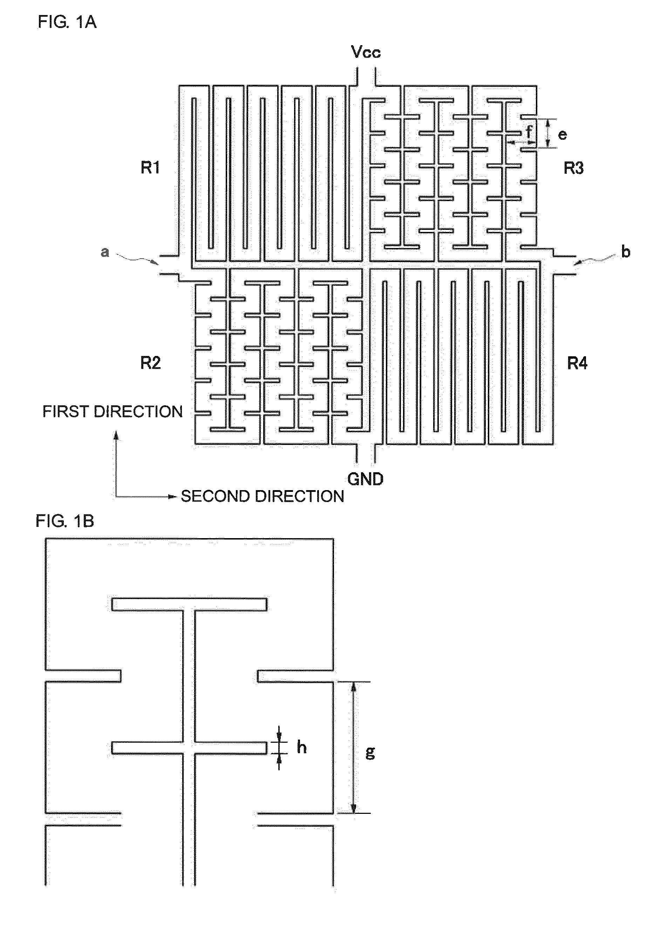

First, a bridge circuit according to a first embodiment of the present invention and a magnetic sensor including the bridge circuit will now be described with reference to the drawings. Fig. 1A is a plan view for describing the bridge circuit in the magnetic sensor according to the first embodiment of the present invention. Fig. 1B is a partially enlarged view for describing the shape of the bridge circuit in detail.

The magnetic sensor according to the present embodiment includes a bridge circuit in which a serial connection body of an MR element R1 and an MR element R2 and a serial connection body of an MR element R3 and an MR element R4 are connected in parallel between power supply voltage Vcc and grounding GND, a comparator (not illustrated) which receives the potential between a node a between the MR element R1 and the MR element R2 and a node b between the MR element R3 and the MR element R4 to have an output corresponding to corresponding to the potential difference between both the nodes, and a feedback resistor (not illustrated) which feeds back the output from the comparator to one input, as illustrated in Fig. 1A. Such circuit elements are formed in the same chip to compose the magnetic sensor.

In addition, the magnetic sensor is featured in the pattern of the MR elements R1 to R4 composing the bridge circuit. Specifically, as illustrated in Fig. 1A, in each of the MR element R1 and the MR element R4 in the bridge circuit, multiple strips along a direction substantially orthogonal to a magnetic-field detection direction are arranged in parallel at certain intervals and are sequentially connected so as to be folded back to form a zigzag pattern in which the multiple strips are electrically connected in series to each other. In addition, as illustrated in Fig. 1A, in each of the MR element R2 and the MR element R3 in the bridge circuit, multiple strips, on the whole, along the direction substantially orthogonal to the magnetic-field detection direction are arranged in parallel at certain intervals and are sequentially connected so as to be folded back and, in each of the multiple strips, multiple strips along the magnetic-field detection direction are arranged in parallel at certain intervals and are sequentially connected so as to be folded back to form a zigzag pattern in which the multiple strips are electrically connected in series to each other. The portions that are folded back to be connected are formed into a substantially linear U shape.

More specifically, as illustrated in Fig. 1A, the MR elements R2 and R3 are composed of the shortest possible straight lines, and straight lines of the same length, like an element e and an element f in Fig. 1A, are arranged so as to be orthogonal to each other to compose the MR elements R2 and R3. In other words, as for the MR element R2, the length of the straight lines in a first direction in Fig. 1A is made equal to the length of the straight lines in a second direction orthogonal to the first direction. Also as for the MR element R3, the length of the straight lines in the first direction is made equal to the length of the straight lines in the second direction.

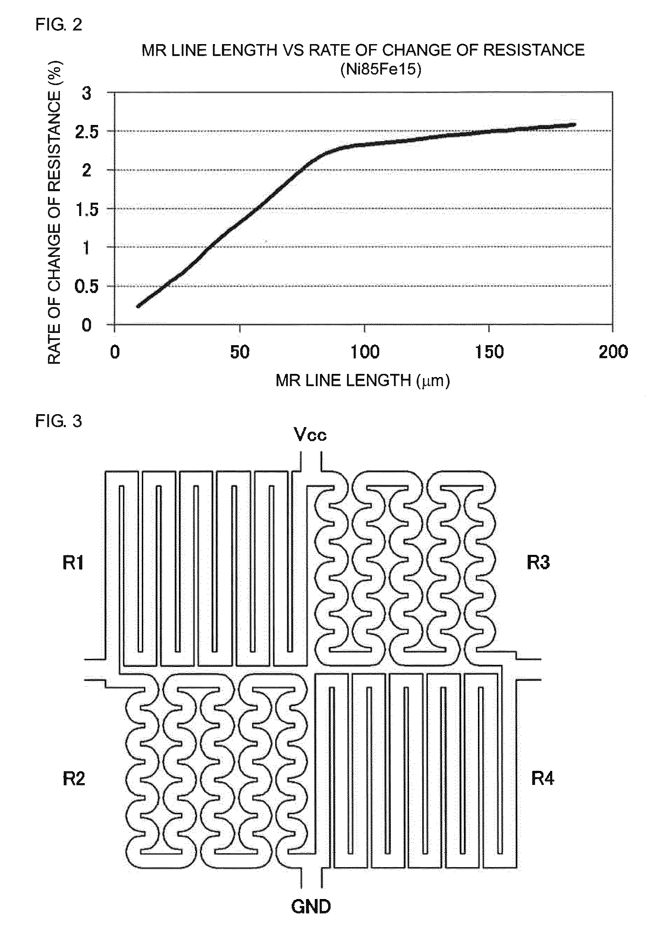

Since each of the MR elements R2 and R3 is composed of the short lines, the resistance change of the MR elements, which are anisotropic magneto-resistance elements, relative to the magnetic field is greatly smaller than that of the MR elements R1 and R4. Fig. 2 illustrates the relationship between the line length of the MR element and the rate of change of resistance. A case in which the MR element is made of $Ni_{0.85}Fe_{0.15}$ is illustrated in Fig. 2. For example, when a length h resulting from exclusion of an area overlapped with the orthogonal pattern from a line g in Fig. 1B is shorter than or equal to 10 $\mu$m, the change of resistance of the MR element is reduced to 1/5 or less, compared with lines of 80 $\mu$m or longer, as illustrated in Fig. 5.

Arranging the MR elements having the same shape so as to be orthogonal to each other as the R2 and R3 produces a resistance value R represented by (Formula 3) when the magnetic field of $\angle\theta$ is applied:

$$(Formula\ 3)$$

$$R = (R0 - \Delta R \times sin^2\theta) + (R0 - \Delta R \times cos^2\theta)$$
$$R = 2R0 - \Delta R(sin^2\theta + cos^2\theta)$$

$$R = 2R0 - \Delta R$$

Accordingly, the resistance value R does not theoretically depend on the angle of the applied magnetic field.

As described above, when the bridge circuit in Fig. 5 composed of the MR elements in Fig. 1A is considered, the MR elements R2 and R3 have significantly small resistance change due to the magnetic field and do not depend on the direction of the magnetic field. Consequently, the offset voltage is equal to (Formula 2). The relationship between the magnetic field of $\angle\theta$ and the mid-point potential is represented by the curve d illustrated in Fig. 7. Accordingly, the MR sensor having a large rotation detection angle is provided.

According to the magnetic sensor of the present embodiment, the magnetic-field detection angle range is increased. For example, when magnetic field of $\theta=45°$ is applied, the magnetic sensor composed of the MR elements in Fig. 6 does not operate because all the resistances of the MR elements R1 to R4 are varied in the same manner. In contrast, the magnetic sensor composed of the MR elements in Fig. 1A is capable of operating.

(Second embodiment)

Next, a bridge circuit according to a second embodiment of the present invention and a magnetic sensor including the bridge circuit will now be described with reference to the drawing. Fig. 3 is a plan view for describing the bridge circuit in the magnetic sensor according to the second embodiment of the present invention. A detailed description of the content common to the first embodiment is omitted herein.

The magnetic sensor of the present embodiment differs from the first embodiment in the pattern shape of the MR elements R1 to R4 composing the bridge circuit. Specifically, as illustrated in Fig. 3, in each of the MR element R1 and the MR element R4 in the bridge circuit, multiple strips along a direction substantially orthogonal to the magnetic-field detection direction are arranged in parallel at certain intervals and are sequentially connected so as to be folded back to form a zigzag pattern in which the multiple strips are electrically connected in series to each other. In addition, as illustrated in Fig. 3, in each of the MR element R2 and the MR element R3 in the bridge circuit, multiple strips, on the whole, along the direction substantially orthogonal to the magnetic-field detection direction are arranged in parallel at certain intervals and are sequentially connected so as to be folded back and, in each of the multiple strips, multiple strips along the magnetic-field detection direction are arranged in parallel at certain intervals and are sequentially connected so as to be folded back to form a zigzag pattern in which the multiple strips are electrically connected in series to each other.

As illustrated in Fig. 3, in the present embodiment, in the MR elements R2 and the MR element R3 in the bridge circuit, the multiple strips are sequentially connected so as to be folded back in a pattern including multiple 180-degree R shapes to form the zigzag pattern in which the multiple strips are electrically connected in series to each other. In other words, the portions that are folded back to be connected are formed into a substantially non-linear U shape.

Also when the MR element R2 and the MR element R3 having the shape and the pattern in the present embodiment are used, the MR element R2 and the MR element R3 do not depend on the direction of the magnetic field and the magnetic-field detection angle range is increased, as in the magnetic sensor of the first embodiment.

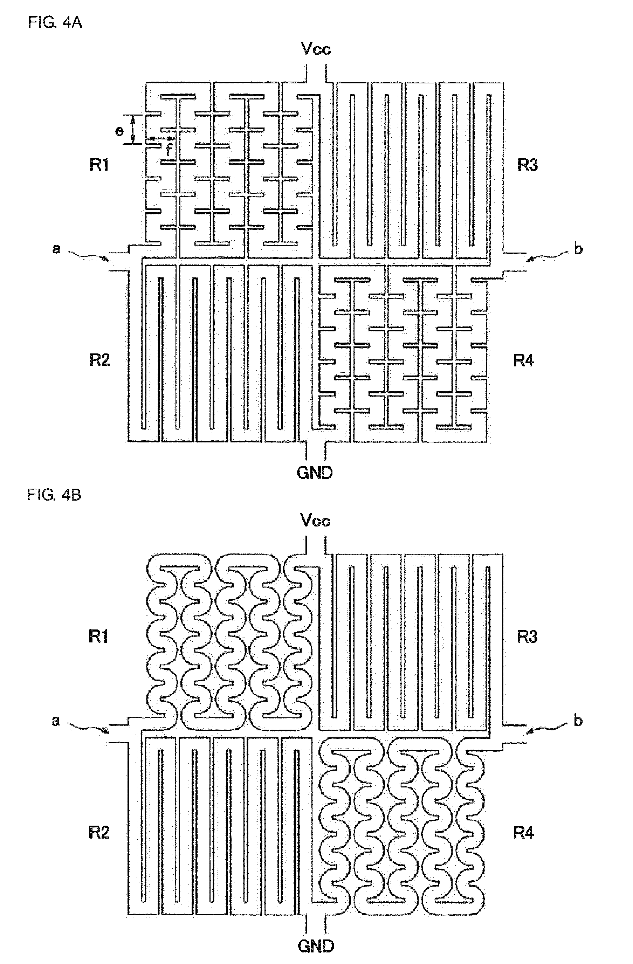

Although the preferred embodiments of the present invention are described above, the present invention is not limited to the above embodiments. The arrangement of the pattern of the MR elements in the bridge circuit is not limited to the first embodiment illustrated in Fig. 1A and Fig. 1B and to the second embodiment illustrated in Fig. 3. For example, patterns of the MR elements in the bridge circuit illustrated in Fig. 4A and Fig. 4B may be adopted.

Fig. 4A is a modification of Fig. 1A and Fig. 1B. In each of the MR elements R1 and R4, multiple strips, on the whole, along the direction substantially orthogonal to the magnetic-field detection direction are arranged in parallel at certain intervals and are sequentially connected so as to be folded back and, in each of the multiple strips, multiple strips along the magnetic-field detection direction are arranged in parallel at certain intervals and are sequentially connected so as to be folded back to form a zigzag pattern in which the multiple strips are electrically connected in series to each other.

Fig. 4B is a modification of Fig. 3. In each of the MR elements R1 and R4, multiple strips, on the whole, along the direction substantially orthogonal to the magnetic-field detection direction are arranged in parallel at certain intervals and are sequentially connected so as to be folded back and, in each of the multiple strips, multiple strips along the magnetic-field detection direction are arranged in parallel at certain intervals and are sequentially connected so as to be folded back to form a zigzag pattern in which the multiple strips are electrically connected in series to each other. As in the case in Fig. 3, the multiple strips are sequentially connected so as to be folded back in the pattern including the multiple 180-degree R shapes to form the zigzag pattern in which the multiple strips are electrically connected in series to each other.

In these cases, the MR elements R1 and R4 have significantly small resistance change due to the magnetic field and do not depend on the direction of the magnetic field. Accordingly, the MR sensor having a large rotation detection angle is provided.

Although the comparator and the feedback resistor are formed in the same chip as that of the bridge circuit in the first embodiment, the comparator and the feedback resistor may be formed in a different chip.

Although the invention of the present application is described above with reference to the preferred embodiments, the invention of the present application is not limited to the above embodiments. Various changes and modified embodiments of the configuration and the detailed portions of the invention of the present application will be obvious to those skilled in the art without departing from the scope of the invention of the present application.

This application is based upon and claims the benefit of priority of the prior Japanese Patent Application No. 2012-112497, filed on May 16, 2012, the entire contents of which are incorporated herein by reference.

Industrial Applicability

Electronic devices and industrial equipment requiring the position detection are considered as exemplary applications of the present invention.

Reference Signs List

R1, R2, R3, R4 MR element
a, b node
g line

**Claims**

1.  A magnetic sensor comprising:

    a bridge circuit in which a serial connection body of a first MR element and a second MR element and a serial connection body of a third MR element and a fourth MR element are connected in parallel between power supplies, and a comparator that receives potential between a node between the first MR element and the second MR element and a node between the third MR element and the fourth MR element to have an output corresponding to a potential difference between both the nodes,

wherein, in each of the first and fourth MR elements in the bridge circuit, multiple strips along a direction substantially orthogonal to a magnetic-field detection direction are arranged in parallel at certain intervals and are sequentially connected so as to be folded back to form a zigzag pattern in which the multiple strips are electrically connected in series to each other, and

wherein, in each of the second and third MR elements in the bridge circuit, multiple strips, on the whole, along the direction substantially orthogonal to the magnetic-field detection direction are arranged in parallel at certain intervals and are sequentially connected so as to be folded back and, in each of the multiple strips, multiple strips along the magnetic-field detection direction are arranged in parallel at certain intervals and are sequentially connected so as to be folded back to form a zigzag pattern in which the multiple strips are electrically connected in series to each other.

2. The magnetic sensor according to Claim 1,
wherein the multiple strips in the second and third MR elements are shorter than the multiple strips in the first and fourth MR elements.

3. The magnetic sensor according to Claim 1 or 2,
wherein each of the second and third MR elements is composed of multiple straight lines and a straight-line distance resulting from exclusion of an area where the straight lines intersect with each other is shorter than or equal to 10 $\mu$m.

4. The magnetic sensor according to any of Claims 1 to 3,
wherein, in each of the second and third MR elements, the multiple strips are sequentially connected so as to be folded back in a pattern including multiple 180-degree R shapes.

5. The magnetic sensor according to any of Claims 1 to 3,
wherein, in each of the first and fourth MR elements, the portions that are folded back to be connected are formed into a substantially linear U shape.

6. The magnetic sensor according to any of Claims 1 to 3,
wherein, in each of the first and fourth MR elements, the portions that are folded back to be connected are formed into a substantially non-linear U shape.

7. A bridge circuit in which a serial connection body of a first MR element and a second MR element and a serial connection body of a third MR element and a fourth MR element are connected in parallel between power supplies,
wherein, in each of the first and fourth MR elements, multiple strips along a direction substantially orthogonal to a magnetic-field detection direction are arranged in parallel at certain intervals and are sequentially connected so as to be folded back to form a zigzag pattern in which the multiple strips are electrically connected in series to each other, and
wherein, in each of the second and third MR elements, multiple strips, on the whole, along the direction substantially orthogonal to the magnetic-field detection direction are arranged in parallel at certain intervals and are sequentially connected so as to be folded back and, in each of the multiple strips, multiple strips along the magnetic-field detection direction are arranged in parallel at certain intervals and are sequentially connected so as to be folded back to form a zigzag pattern in which the multiple strips are electrically connected in series to each other.

8. The bridge circuit according to Claim 7,
wherein the multiple strips in the second and third MR elements are shorter than the multiple strips in the first and fourth MR elements.

9. The bridge circuit according to Claim 7 or 8,
wherein each of the second and third MR elements is composed of multiple straight lines and a straight-line distance resulting from exclusion of an area where the straight lines intersect with each other is shorter than or equal to 10 $\mu$m.

FIG. 1A

Vcc

R1

R3

a

b

R2

R4

FIRST DIRECTION

SECOND DIRECTION

GND

e f

FIG. 1B

h

g

FIG. 2

FIG. 3

FIG. 4A

FIG. 4B

FIG. 5

FIG. 6

MAGNETIC FIELD

FIG. 7

OFFSET
VOLTAGE

OFFSET VOLTAGE
VALUE UNDER NO
MAGNETIC FIELD

MAGNETIC FIELD ANGLE (θ)

## INTERNATIONAL SEARCH REPORT

| | International application No. |
|---|---|
| | PCT/JP2013/002703 |

**A. CLASSIFICATION OF SUBJECT MATTER**
*G01R33/09*(2006.01)i, *H01L43/08*(2006.01)i

According to International Patent Classification (IPC) or to both national classification and IPC

**B. FIELDS SEARCHED**

Minimum documentation searched (classification system followed by classification symbols)
G01R33/09, H01L43/08

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | WO 2009/031539 A1 (Alps Electric Co., Ltd.), 12 March 2009 (12.03.2009), entire text; all drawings & US 2010/0141251 A1 | 1-9 |
| Y | JP 2-231587 A (Tokai Rika Co., Ltd.), 13 September 1990 (13.09.1990), page 3, upper left column, line 19 to page 5, lower right column, line 11; fig. 1 to 7 (Family: none) | 1-9 |

☐ Further documents are listed in the continuation of Box C.    ☐ See patent family annex.

| | |
|---|---|
| *   Special categories of cited documents: | "T"   later document published after the international filing date or priority date and not in conflict with the application but cited to understand the principle or theory underlying the invention |
| "A"   document defining the general state of the art which is not considered to be of particular relevance | |
| "E"   earlier application or patent but published on or after the international filing date | "X"   document of particular relevance; the claimed invention cannot be considered novel or cannot be considered to involve an inventive step when the document is taken alone |
| "L"   document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&"   document member of the same patent family |

| Date of the actual completion of the international search | Date of mailing of the international search report |
|---|---|
| 24 June, 2013 (24.06.13) | 09 July, 2013 (09.07.13) |

| Name and mailing address of the ISA/ | Authorized officer |
|---|---|
| Japanese Patent Office | |
| Facsimile No. | Telephone No. |

Form PCT/ISA/210 (second sheet) (July 2009)

**EP 2 853 909 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007225421 A
- JP 2012112497 A